(19) **Europäisches Patentamt European Patent Office Office européen des brevets**

(11) **EP 2 769 229 B1**

(12) **FASCICULE DE BREVET EUROPEEN**

(45) Date de publication et mention de la délivrance du brevet:
**04.12.2019 Bulletin 2019/49**

(21) Numéro de dépôt: **12787766.0**

(22) Date de dépôt: **16.10.2012**

(51) Int Cl.:
*G01R 11/19* [(2006.01)]   *G01R 21/06* [(2006.01)]
*H01F 30/12* [(2006.01)]   *G01R 29/16* [(2006.01)]
*G01R 23/20* [(2006.01)]   *G01R 19/25* [(2006.01)]

(86) Numéro de dépôt international:
**PCT/FR2012/052351**

(87) Numéro de publication internationale:
**WO 2013/057416 (25.04.2013 Gazette 2013/17)**

(54) **PROCEDE ET DISPOSITIF D'ANALYSE DE LA QUALITE DE L'ENERGIE ELECTRIQUE DANS UN RESEAU ELECTRIQUE TRIPHASE**

VERFAHREN UND GERÄT ZUR QUALITÄTSANALYSE VON ELEKTRISCHER ENERGIE IN DREHSTROMNETZWERKEN

METHOD AND DEVICE FOR ANALYSING THE QUALITY OF ELECTRIC ENERGY IN A THREE PHASE NETWORK

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **19.10.2011 FR 1159449**

(43) Date de publication de la demande:
**27.08.2014 Bulletin 2014/35**

(73) Titulaire: **Schneider Electric Industries SAS 92500 Rueil-Malmaison (FR)**

(72) Inventeurs:
• **LEPRETTRE, Benoît**
  **F-38050 Cedex 09 Grenoble (FR)**
• **CRACIUN, Octavian**
  **F-38050 Cedex 09 Grenoble (FR)**
• **BACHA, Séddik**
  **F-38050 Cedex 09 Grenoble (FR)**
• **GRANJON, Pierre**
  **F-38050 Cedex 09 Grenoble (FR)**
• **RADU, Daniel**
  **F-38050 Cedex 09 Grenoble (FR)**

(74) Mandataire: **Tripodi, Paul**
  **Schneider Electric Industries SAS**
  **Service Propriété Industrielle**
  **World Trade Center / 38EE1**
  **5 Place Robert Schuman**
  **38050 Grenoble Cedex 09 (FR)**

(56) Documents cités:
**WO-A1-2004/081591    US-A1- 2003 014 200**
**US-A1- 2007 296 381**

• **FERRERO A ET AL: "A park-vector approach to displacement and distortion in three-phase systems: the role of the power factor and the imaginary power", HARMONICS AND QUALITY OF POWER, 2004. 11TH INTERNATIONAL CONFERENCE ON LAKE PLACID, NY, USA 12-15 SEPT. 2004, PISCATAWAY, NJ, USA,IEEE, US, 12 septembre 2004 (2004-09-12), pages 745-752, XP010778570, DOI: 10.1109/ICHQP.2004.1409446 ISBN: 978-0-7803-8746-1**
• **CHATTOPADHYAY S ET AL: "Power quality assessment in V-V, Clarke and Park domain", UNIVERSITIES POWER ENGINEERING CONFERENCE, 2007. UPEC 2007. 42ND INTERNATIONAL, IEEE, PISCATAWAY, NJ, USA, 4 septembre 2007 (2007-09-04), pages 669-676, XP031237603, ISBN: 978-1-905593-36-1**
• **RUIXIANP HAO ET AL: "A novel harmonic currents detection method based on rotating d-q reference frame for active power filter", POWER ELECTRONICS SPECIALISTS CONFERENCE, 2004. PESC 04. 2004 IEEE 35TH ANNUAL, AACHEN, GERMANY 20-25 JUNE 2004, PISCATAWAY, NJ, USA,IEEE, US, 20 juin 2004 (2004-06-20), pages 4034-4038, XP010739749, ISBN: 978-0-7803-8399-9**

- **SHUHONG KONG ET AL: "Design of voltage unbalance generating device based on negative sequence injection method", INDUSTRIAL ELECTRONICS AND APPLICATIONS (ICIEA), 2010 THE 5TH IEEE CONFERENCE ON, IEEE, PISCATAWAY, NJ, USA, 15 juin 2010 (2010-06-15), pages 1305-1308, XP031711732, ISBN: 978-1-4244-5045-9**

**Description**

**DOMAINE TECHNIQUE**

La présente invention concerne l'analyse de la qualité de l'énergie électrique dans un réseau électrique.

De manière générale, la qualité de l'énergie électrique dans un réseau peut être représentée par une combinaison entre la qualité de la tension et la qualité du courant. Cependant, pour un réseau triphasé, la qualité de l'énergie électrique est plus complexe à définir. En effet, un réseau électrique triphasé est considéré comme sain, ou non perturbé, si la forme d'onde, l'amplitude, la fréquence et la symétrie restent respectivement dans des limites prédéfinies.

En outre, la détermination de valeurs électriques telles que valeur efficace de courant ou de tension, puissance active totale, puissance apparente totale, puissance réactive totale, permet notamment de maîtriser la consommation d'énergie d'une installation.

La présente invention concerne plus particulièrement les réseaux triphasés. Les perturbations les plus courantes qui les affectent sont les creux de tension ou de courant, les surtensions ou les surintensités, la pollution harmonique, les déséquilibres et les papillotements de tension (flicker).

**ÉTAT DE LA TECHNIQUE ANTÉRIEURE**

Les méthodes connues de surveillance de la qualité de l'énergie électrique dans un réseau électrique triphasé consistent en une analyse phase par phase des perturbations et des valeurs électriques.

Pour caractériser globalement la consommation et la qualité de l'énergie électrique dans un réseau triphasé, les méthodes connues consistent à sommer ou moyenner les résultats obtenus pour chaque phase. Or ces méthodes ne sont pas totalement satisfaisantes. En effet, un résultat de mesure sur une phase n'est pas toujours pertinent dans un réseau triphasé. Si on réalise par exemple une moyenne arithmétique de résultats de mesure effectuées phase par phase, on n'obtient pas nécessairement une caractérisation du réseau triphasé du point de vue physique. En outre, lors d'une sommation de grandeurs monophasées, les erreurs de mesure s'additionnent.

Le document EP 0 599 648 décrit une méthode de calcul des composantes directe, inverse et homopolaire dans un réseau électrique triphasé pour détecter un déséquilibre. Cette détection de déséquilibre est fondée sur des calculs complexes, long et peu précis. Elle ne permet pas de quantifier un taux de déséquilibre. Enfin, ce document ne s'intéresse qu'aux déséquilibres et ne prend pas en compte toutes les perturbations qui peuvent affecter un réseau électrique triphasé.

Des procédés d'analyse de la qualité de l'énergie électrique dans un réseau triphasé sont aussi décrit dans :

- le document [FERRERO A ET AL: "A park-vector approach to displacement and distortion in three-phase systems: the role of the power factor and the imaginary power", HARMONICS AND QUALITY OF POWER, 2004. 11TH INTERNATIONAL CONFERENCE ON LAKE PLACID, NY, USA 12-15 SEPT. 2004, PISCATAWAY, NJ, USA,IEEE, US, 12 septembre 2004 (2004-09-12), pages 745-752, XP01 0778570, DOI: 10.11 09/ICHQP.2004.1409446 ISBN: 978-0-7803-8746-1], et
- le document [CHATTOPADHYAY S ET AL: "Power quality assessment in V-V, Clarke and Park domain", UNIVERSITIES POWER ENGINEERING CONFERENCE, 2007. UPEC 2007. 42ND INTERNATIONAL, IEEE, PISCATAWAY, NJ, USA, 4 septembre 2007 (2007-09-04), pages 669-676, XP031237603, ISBN: 978-1-905593-36-1].

Ainsi, les méthodes et dispositifs connus ne permettent pas d'effectuer une mesure globale triphasée de la qualité de l'énergie électrique dans un réseau triphasé.

**EXPOSÉ DE L'INVENTION**

L'invention vise à résoudre les problèmes de la technique antérieure en fournissant un procédé et un dispositif d'analyse de la qualité de l'énergie électrique dans un réseau électrique triphasé, définis dans les revendications.

Grâce à l'invention, il est possible de quantifier et caractériser de manière globale les différents types de perturbations électriques qui peuvent survenir dans un réseau triphasé.

La précision et le temps de calcul sont significativement améliorés.

Ainsi, il est possible de surveiller la qualité de l'énergie électrique dans un réseau triphasé de manière plus précise et plus rapide. Cela permet de mieux comprendre l'origine des éventuelles perturbations et de mieux évaluer leur impact sur les équipements électriques présents dans le réseau.

L'invention repose sur la détermination et l'utilisation du vecteur d'espace, qui contient toute l'information du système triphasé.

Selon une caractéristique préférée, l'ensemble comportant au moins un paramètre représentatif de la qualité de l'énergie électrique dans le réseau électrique triphasé comporte au moins un paramètre choisi parmi :

- un paramètre représentatif d'un déséquilibre de tension ou de courant dans le réseau triphasé,
- un paramètre représentatif d'un creux de tension ou de courant,
- un paramètre représentatif d'une surtension ou d'une surintensité,
- un paramètre représentatif d'un papillotement de tension.

Ces paramètres représentent les perturbations les plus courantes et les plus pertinentes pour l'analyse de la qualité de l'énergie électrique dans un réseau triphasé.

Selon une caractéristique préférée, le procédé d'analyse comporte en outre la formation d'une composante homopolaire à partir de la transformation tridimensionnelle instantanée de l'ensemble des grandeurs électriques mesurées.

Dans ce cas, la détermination de l'ensemble comportant au moins un paramètre représentatif de la qualité de l'énergie électrique dans le réseau électrique triphasé est en outre effectuée en fonction de la composante homopolaire et ledit au moins un paramètre représente une pollution harmonique de tension ou de courant.

Selon une caractéristique préférée, le procédé comporte en outre la détermination d'au moins un paramètre énergétique du réseau électrique triphasé en fonction du vecteur d'espace et de la composante homopolaire.

Selon une caractéristique préférée, l'au moins un paramètre énergétique est choisi parmi :

- Une valeur efficace totale de courant ou de tension,
- Une puissance active totale,
- Une puissance apparente totale,
- Une puissance réactive totale.

Les paramètres énergétiques permettent de déterminer des consommations énergétiques triphasées, par intégration dans le temps.

Selon une caractéristique préférée, le procédé comporte en outre une étape d'affichage d'une forme parcourue par le vecteur d'espace dans le plan complexe.

Ce type d'affichage donne une indication visuelle de la présence de perturbation qui est très rapide à détecter pour un utilisateur.

Le dispositif comporte des moyens de mise en œuvre de ces caractéristiques et présente des avantages analogues.

Dans un mode particulier de réalisation, les étapes du procédé selon l'invention sont mises en œuvre par des instructions de programme d'ordinateur.

En conséquence, l'invention vise aussi un programme d'ordinateur sur un support d'informations, ce programme étant susceptible d'être mis en œuvre dans un ordinateur, ce programme comportant des instructions adaptées à la mise en œuvre des étapes d'un procédé tel que décrit ci-dessus.

Ce programme peut utiliser n'importe quel langage de programmation, et être sous la forme de code source, code objet, ou de code intermédiaire entre code source et code objet, tel que dans une forme partiellement compilée, ou dans n'importe quelle autre forme souhaitable.

L'invention vise aussi un support d'informations lisible par un ordinateur, et comportant des instructions de programme d'ordinateur.

Le support d'informations peut être n'importe quelle entité ou dispositif capable de stocker le programme. Par exemple, le support peut comporter un moyen de stockage, tel qu'une ROM, par exemple un CD ROM ou une ROM de circuit microélectronique, ou encore un moyen d'enregistrement magnétique, par exemple une disquette ou un disque dur.

D'autre part, le support d'informations peut être un support transmissible tel qu'un signal électrique ou optique, qui peut être acheminé via un câble électrique ou optique, par radio ou par d'autres moyens. Le programme selon l'invention peut être en particulier téléchargé sur un réseau de type Internet.

Alternativement, le support d'informations peut être un circuit intégré dans lequel le programme est incorporé, le circuit étant adapté pour exécuter ou pour être utilisé dans l'exécution du procédé selon l'invention.

## BRÈVE DESCRIPTION DES DESSINS

D'autres caractéristiques et avantages apparaitront à la lecture d'un mode de réalisation préféré donné à titre d'exemple non limitatif, décrit en référence aux figures dans lesquelles :

- La figure 1 représente un dispositif d'analyse de la qualité de l'énergie électrique dans un réseau triphasé, selon l'invention,

- La figure 2 représente un module de calcul du dispositif de la figure 1,
- La figure 3 représente un mode de réalisation du dispositif selon l'invention,
- La figure 4 représente un mode de réalisation du procédé d'analyse de la qualité de l'énergie électrique dans un réseau triphasé, selon l'invention.

## EXPOSÉ DÉTAILLÉ DE MODES DE RÉALISATION PARTICULIERS

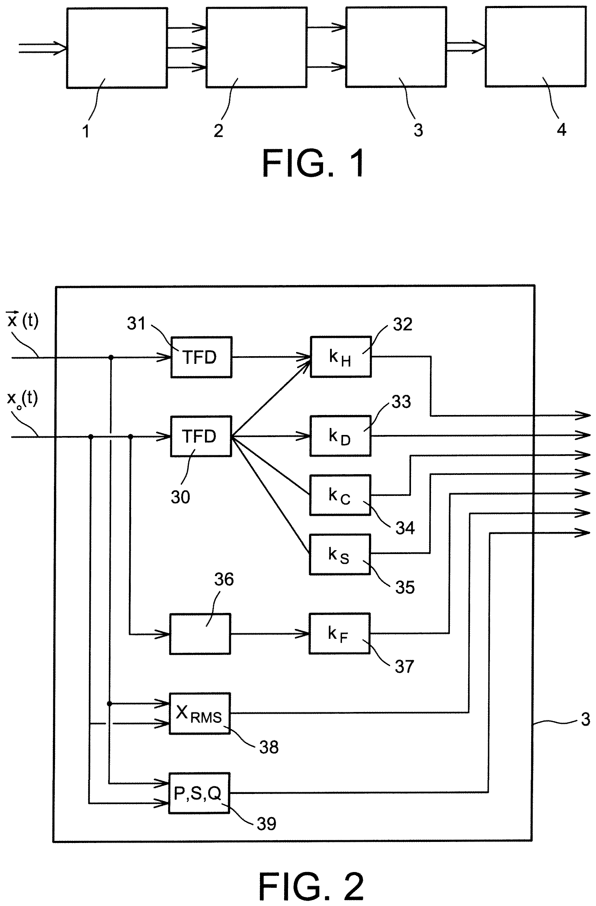

Selon un mode de réalisation représenté à la **figure 1,** un dispositif d'analyse de la qualité de l'énergie électrique dans un réseau triphasé comporte un module 1 d'acquisition de données. Le module 1 comporte une interface d'entrée apte à être connectée à chaque phase du réseau électrique triphasé pour en mesurer des grandeurs électriques en un point du réseau. Ces grandeurs sont les tensions instantanées et/ou les courants instantanés des phases. Ces mesures en elles-mêmes sont classiques et ne seront pas détaillées ici. On suppose dans la suite que le réseau est un réseau triphasé.

Le module 1 comporte une interface de sortie qui est reliée à une interface d'entrée d'un module 2 de transformation tridimensionnelle instantanée. Le module 1 transmet au module 2 autant de grandeurs électriques mesurées que le réseau comporte de phases. Ces grandeurs électriques sont des valeurs de tensions et/ou de courant.

A un instant donné, le module 2 reçoit trois mesures $x_a(t)$, $x_b(t)$ et $x_c(t)$ qui sont les valeurs instantanées des tensions ou des courants de phase mesurées en un point du réseau triphasé. Le module 2 réalise une transformation dérivée de celle des composantes symétriques et définie par la transformation de Clarke :

$$\begin{bmatrix} x_\alpha(t) \\ x_\beta(t) \\ x_0(t) \end{bmatrix} = \mathrm{k} \cdot \begin{bmatrix} 1 & -1/2 & -1/2 \\ 0 & \dfrac{\sqrt{3}}{2} & -\dfrac{\sqrt{3}}{2} \\ 1/2 & 1/2 & 1/2 \end{bmatrix} \cdot \begin{bmatrix} x_a(t) \\ x_b(t) \\ x_c(t) \end{bmatrix}$$

Les deux premières composantes obtenues après transformation sont combinées pour former un nombre complexe dépendant du temps appelé vecteur d'espace :

$$\vec{x}(t) = x_\alpha(t) + j.x_\beta(t)$$

Ces deux équations forment la transformation tridimensionnelle instantanée. Le vecteur d'espace contient toute l'information du système triphasé original.

Lorsque le système triphasé est équilibré, le vecteur d'espace parcourt un cercle dans le plan complexe. Une perturbation provoque une déformation du vecteur d'espace visible dans le plan complexe. Les déformations permettent de caractériser et quantifier les différentes perturbations affectant le réseau électrique triphasé.

La transformation tridimensionnelle instantanée a également pour résultat la composante homopolaire $x_0(t)$ qui est une grandeur à valeur réelle.

Le module 2 comporte une interface de sortie qui est reliée à une interface d'entrée d'un module 3 de détermination d'au moins un paramètre représentatif de la qualité de l'énergie électrique dans le réseau électrique triphasé. Le module 2 transmet au module 3 le vecteur d'espace et éventuellement la composante homopolaire. Dans la suite, sauf mention contraire, il s'agit aussi bien d'un vecteur d'espace tension et d'une composante homopolaire tension que d'un vecteur d'espace courant et une composante homopolaire courant.

Le module 3 reçoit le vecteur d'espace et éventuellement la composante homopolaire et les utilise pour déterminer un ou des paramètres représentatifs de la qualité de l'énergie électrique. Il est à noter que, comme exposé dans la suite, selon le paramètre qui est déterminé, la composante homopolaire n'est pas toujours nécessaire. Si la composante homopolaire n'est pas nécessaire, le module 2 ne la transmet pas obligatoirement au module 3.

Les calculs effectués par le module 3 peuvent être effectués selon la norme CEI 61000-4-30 : Compatibilité électromagnétique (CEM) - partie 4-30 : Techniques d'essai et de mesure - Méthode de mesure de la qualité de l'alimentation.

En référence à la **figure 2,** le module 3 détermine un ou plusieurs paramètre(s) représentatif(s) de la qualité de l'énergie électrique dans le réseau.

Ces paramètres sont choisis parmi :

- Un taux $k_H$ de distorsion harmonique triphasé, qui représente la pollution harmonique de tension ou de courant,
- Un taux $k_D$ de déséquilibre triphasé, qui représente les déséquilibres de tension ou de courant,

EP 2 769 229 B1

- Un indicateur $k_C$ de creux de tension ou de courant triphasé, qui représente les creux de tension ou de courant,
- Un indicateur $k_S$ de surtension ou de surintensité triphasée, qui représente les surtensions ou surintensités,
- Un taux $k_F$ de papillotement de tension, ou « flicker », qui représente les papillotements de tension.

Le calcul de chacun de ces paramètres utilise le vecteur d'espace. Pour le taux $k_H$ de distorsion harmonique de tension ou de courant, la composante homopolaire est en outre utilisée. On présente dans la suite le détail de la détermination de ces paramètres.

Des sous-modules 30 et 31 du module 3 reçoivent respectivement le vecteur d'espace et la composante homopolaire depuis le module 2 et leur appliquent chacun une transformée de Fourier. Les sous-modules 30 et 31 délivrent respectivement en sortie les spectres d'amplitude de ces deux grandeurs. Il est à noter que le sous-module 31 effectue en pratique une transformée de Fourier pour la partie réelle du vecteur d'espace et une transformée de Fourier pour sa partie imaginaire.

Le contenu harmonique d'un système triphasé peut être analysé à partir du vecteur d'espace et de la composante homopolaire.

On utilise les amplitudes des harmoniques à chaque fréquence pour calculer le taux $k_H$ de distorsion harmonique globale du système triphasé.

Les harmoniques sont réparties dans le spectre du vecteur d'espace et/ou de la composante homopolaire à des fréquences données, en fonction de leur rang n et de leur répartition sur les trois phases.

Le taux $k_H$ de distorsion harmonique globale du système triphasé est calculé par un sous-module 32 du module 3, dont des entrées sont reliées aux sorties des sous-modules 30 et 31, selon la formule suivante :

$$k_H = \frac{\sqrt{\sum_{n=2}^{\infty}\left(\left|X_d^n\right|^2 + \left|X_i^n\right|^2 + \left|X_h^n\right|^2\right)}}{\sqrt{\left(\left|X_d^1\right|^2 + \left|X_i^1\right|^2 + \left|X_h^1\right|^2\right)}}.100\left[\%\right]$$

où $X_d^n$, $X_i^n$ et $X_h^n$ sont les composantes directe, inverse et homopolaire de l'harmonique de rang n, qui sont calculées par transformée de Fourier du vecteur d'espace et de la composante homopolaire. Ces composantes peuvent inclure le contenu de fréquences adjacentes de part et d'autre de l'harmonique de rang n, comme décrit dans la norme CEI 61000-4-30.

Le dénominateur de la formule précédente représente la valeur efficace de l'ensemble des composantes triphasées harmoniques de rang égal à 1. Le numérateur représente la valeur efficace de l'ensemble des composantes triphasées harmoniques de rang supérieur à 1.

Le taux $k_H$ de distorsion harmonique globale du système triphasé est estimé sur une fenêtre glissante sur laquelle les spectres du vecteur d'espace et de la composante homopolaire sont calculés puis la formule du taux $k_H$ est appliquée.

La durée de la fenêtre est par exemple de 200 ms, en conformité avec la norme CEI 61000-4-30. Cette durée répond à deux critères antagonistes :

- Elle est suffisamment petite pour minimiser le temps de réponse du traitement et permettre de suivre les variations rapides du taux $k_H$ ;
- Elle est suffisamment grande pour avoir une résolution spectrale satisfaisante pour bien séparer les composantes contenues dans les signaux analysées. La résolution est l'inverse de la durée de la fenêtre, elle est donc de 5 Hz.

Le déséquilibre de tension ou de courant dans un système triphasé est déterminé à partir du vecteur d'espace de tension ou de courant, par un sous-module 33 du module 3, dont une entrée est reliée à la sortie du sous-module 30.

Un déséquilibre dans un système triphasé est défini par la norme CEI 61000-4-30 comme le rapport entre la tension ou le courant direct (e) et la tension ou le courant inverse, à la fréquence fondamentale du système triphasé.

Ainsi, le taux $k_D$ de déséquilibre triphasé représente le rapport des modules de la composante directe et de la composante inverse à la fréquence fondamentale du système triphasé.

Une transformée de Fourier est appliquée au vecteur d'espace par le sous-module 30 qui délivre le spectre d'amplitude de cette grandeur au sous-module 33. Ce dernier utilise ensuite les composantes directe et inverse à la fréquence fondamentale selon la formule suivante :

$$k_D \;=\; \frac{\left|X_i^1\right|}{\left|X_d^1\right|} . 100[\%]$$

En variante, il est possible de calculer les taux de déséquilibre associés aux harmoniques du système triphasé, en appliquant la formule précédente pour les fréquences harmoniques souhaitées.

Le taux de déséquilibre est lui aussi calculé sur une fenêtre glissante dont la durée est par exemple de 200 ms. Ainsi le calcul est effectué en temps réel. La durée de la fenêtre peut être choisie en conformité avec la norme CEI 61000-4-30 et permet à la fois une bonne résolution spectrale (5 Hz) et un temps de réponse court pour la détection des déséquilibres.

Les creux de tension ou de courant sont déterminés à partir du vecteur d'espace, par un sous-module 34 du module 3, dont une entrée est reliée à la sortie du sous-module 30. On considère dans la suite les creux de tension, sachant que les calculs sont transposables au cas des creux de courant.

En l'absence de creux de tension dans le réseau triphasé, le vecteur d'espace tension parcourt dans le plan complexe, à la fréquence fondamentale du réseau, un cercle dont le rayon est égal à la tension nominale $V_{nom}$.

Lorsqu'un creux de tension survient, le vecteur d'espace tension parcourt dans le plan complexe, à la fréquence fondamentale, une ellipse dont le rayon mineur est inférieur à la tension nominale $V_{nom}$. Plus le rayon mineur de l'ellipse est petit, plus le creux est important.

L'indicateur $k_C$ de creux de tension est le rapport entre le rayon mineur de l'ellipse et la tension nominale $V_{nom}$. L'indicateur de creux de tension est déterminé à partir du vecteur d'espace auquel est appliquée une transformée de Fourier par le sous-module 30. On obtient ainsi le spectre d'amplitude de cette grandeur. Le sous-module 30 le délivre au sous-module 34 qui détermine ensuite les modules des composantes directe et inverse à la fréquence fondamentale, et les utilise selon la formule suivante :

$$k_C \;=\; \frac{\left|X_d^1\right| - \left|X_i^1\right|}{V_{nom}}$$

L'indicateur $k_C$ de creux de tension est égal à la différence du module de la composante directe et du module de la composante inverse à la fréquence fondamentale, divisée par la valeur de la tension nominale du réseau.

En pratique, les calculs sont effectués sur une fenêtre glissante dont la longueur temporelle est par exemple égale à deux périodes du fondamental. Cette taille de fenêtre permet d'estimer correctement le spectre du vecteur d'espace, tout en détectant rapidement l'apparition d'un creux.

Lorsque l'indicateur $k_C$ de creux de tension reste proche de 1, par exemple en restant supérieur à un seuil égal à 0,9, il n'y a pas de creux.

Lorsque l'indicateur $k_C$ de creux de tension devient inférieur au seuil fixé pendant une durée donnée, par exemple au moins une demi période fondamentale, un creux est détecté. Plus l'indicateur de creux de tension est proche de 0, plus le creux est important ou profond.

La valeur du seuil de détection et la durée minimale du creux sont par exemple choisies pour être en conformité avec la classe A définie dans la norme CEI 61000-4-30. Elles peuvent être réglables par l'utilisateur.

Les surtensions ou les surintensités sont déterminées à partir du vecteur d'espace, par un sous-module 35 du module 3, dont une entrée est reliée à la sortie du sous-module 30.

On considère dans la suite les surtensions, sachant que les calculs sont transposables au cas des surintensités.

En l'absence de surtension dans le réseau triphasé, le vecteur d'espace tension parcourt dans le plan complexe, à la fréquence fondamentale du réseau, un cercle dont le rayon est égal à la tension nominale $V_{nom}$.

Lorsqu'une surtension survient, le vecteur d'espace tension parcourt dans le plan complexe, à la fréquence fondamentale, une ellipse dont le rayon majeur est supérieur à la tension nominale $V_{nom}$. Plus le rayon majeur de l'ellipse est grand, plus la surtension est importante.

L'indicateur $k_S$ de surtension est déterminé à partir du vecteur d'espace auquel est appliquée une transformée de Fourier par le sous-module 30. On obtient le spectre d'amplitude de cette grandeur. Le sous-module 30 le délivre au sous-module 35 qui détermine ensuite les modules des composantes directe et inverse à la fréquence fondamentale, et les utilise selon la formule suivante :

$$k_S = \frac{\left|X_d^1\right| + \left|X_i^1\right|}{V_{nom}}$$

L'indicateur $k_S$ de surtension est égal à la somme du module de la composante directe et du module de la composante inverse à la fréquence fondamentale, divisée par la valeur de la tension nominale du réseau.

En pratique, les calculs sont effectués sur une fenêtre glissante dont la longueur temporelle est par exemple égale à deux périodes du fondamental. Cette taille de fenêtre permet d'estimer correctement le spectre du vecteur d'espace, tout en détectant rapidement l'apparition d'une surtension.

Lorsque l'indicateur $k_S$ de surtension reste proche de 1, par exemple en restant inférieur à un seuil égal à 1,1, il n'y a pas de surtension.

Lorsque l'indicateur $k_S$ de surtension devient supérieur au seuil fixé pendant une durée donnée, par exemple au moins une demi période fondamentale, une surtension est détectée. Plus l'indicateur $k_S$ de surtension est grand, plus la surtension est importante.

La valeur du seuil de détection et la durée minimale de la surtension sont par exemple choisies pour être en conformité avec la classe A définie dans la norme CEI 61000-4-30. Elles peuvent être réglables par l'utilisateur.

Un papillotement de tension de type « flicker » est mesuré à partir du vecteur d'espace, par un sous-module 37 du module 3.

De manière classique, un papillotement de tension est mesuré pour une phase, par un appareil appelé flickermètre. L'entrée du flickermètre est une tension de phase qui est une grandeur à valeur réelle.

Selon l'invention, un sous-module 36 est relié à l'entrée du module 3. Le sous-module 36 reçoit le vecteur d'espace tension. Il détermine la partie réelle du vecteur d'espace tension puis la délivre à l'entrée du sous-module 37 qui est un flickermètre. Ainsi c'est l'information triphasée contenue dans la partie réelle du vecteur d'espace tension qui permet d'analyser les papillotements de tension. Le flickermètre 37 délivre en sortie le taux de papillotement $k_F$ qui est une mesure globale des papillotements de tension du système triphasé.

En pratique, les calculs sont effectués sur une fenêtre glissante dont la longueur temporelle est par exemple égale à 500 ms. Même si la norme CEI 61000-4-15 précise que la période d'observation pour les papillotements de tension peut être choisie parmi les valeurs suivantes : 1 mn, 5 mn, 10 mn et 15 mn, une durée d'observation plus courte permet une détection rapide des papillotements et un meilleur suivi des papillotements rapides de tension de type flicker.

Selon un mode de réalisation préféré, le module 3 permet en outre de déterminer au moins un paramètre énergétique tel que les valeurs efficaces totales, dites valeurs RMS (de l'anglais Root Mean Square) de la tension et/ou du courant ainsi que différentes puissances totales, telles que puissances totales active, réactive et apparente. Ces puissances servent de base au calcul de la consommation énergétique du système triphasé.

Un sous-module 38 est relié à l'entrée du module 3 et reçoit le vecteur d'espace et la composante homopolaire de la tension et/ou du courant. Le sous-module 38 détermine la valeur efficace totale soit de la tension soit du courant, globalement pour le réseau triphasé, selon la formule suivante :

$$X_{RMS} = \sqrt{\mu_T \left( \frac{x_\alpha^2(t) + x_\beta^2(t)}{2} + x_0^2(t) \right)}$$

Où l'opérateur $\mu_T$ représente l'opération de moyennage sur une période de temps T de préférence égale à un nombre entier de fois la période fondamentale du réseau électrique triphasé.

On peut ainsi déterminer une valeur efficace totale de tension $V_{RMS}$ et/ou une valeur efficace totale de courant $I_{RMS}$.

Un sous-module 39 est relié en entrée du module 3 et reçoit le vecteur d'espace et la composante homopolaire de la tension et du courant. Le sous-module 39 détermine au moins une puissance totale représentative du réseau triphasé.

La puissance active totale triphasée P est calculée selon la formule :

$$P = \frac{3}{2} \cdot \mu_T \left( \vec{i}(t) * \vec{v}(t) \right) + 3 \cdot \mu_T \left( i_0(t) \cdot v_0(t) \right)$$

où $\vec{i}(t)$ et $\vec{v}(t)$ sont respectivement le vecteur espace de courant et le vecteur espace de tension, et l'opérateur * représente le produit scalaire.

La puissance apparente totale triphasée S est calculée selon la formule :

$$S = 3.V_{RMS}.I_{RMS}$$

où $V_{RMS}$ est la valeur efficace totale de tension, $I_{RMS}$ est la valeur efficace totale de courant.

La puissance réactive totale triphasée Q est calculée selon la formule :

$$Q = \pm\sqrt{S^2 - P^2}$$

Le signe de la puissance réactive totale triphasée Q peut être déterminé à partir d'une analyse de puissance au fondamental, faisant intervenir une transformée de Fourier discrète à la fréquence fondamentale du réseau.

En variante, la puissance réactive totale triphasée Q peut être déterminée de manière similaire à la puissance active totale triphasée P, mais en utilisant un signal de tension ou de courant calculé en quadrature par rapport au signal original.

A partir de ces mesures de puissance, on peut déterminer une consommation énergétique totale triphasée, par intégration dans le temps.

Chacun des sous-modules de calcul 32 à 37 et 38 et 39 précédemment décrits a une sortie reliée à une entrée d'un module 4 d'affichage des résultats.

L'affichage des résultats peut être plus ou moins précis en fonction des besoins de l'utilisateur. Ainsi, l'affichage peut par exemple simplement indiquer l'absence ou la présence de perturbations dans le réseau électrique triphasé. Par exemple, la forme parcourue par le vecteur d'espace dans le plan complexe est affichée. Plus cette forme s'éloigne d'un cercle, plus le réseau électrique triphasé est perturbé, c'est-à-dire que la tension et/ou le courant sont non-sinusoïdaux et/ou non-équilibrés.

En variante, un affichage binaire peut être associé à chacun des paramètres déterminés selon l'invention.

L'affichage peut également donner une indication du niveau de gravité des perturbations détectées, par exemple par un code de couleurs ou un curseur sur une échelle graduée.

L'affichage peut aussi afficher une quantification précise des perturbations détectées, par exemple à l'aide de courbes et/ou de valeurs numériques.

Des alarmes visuelles ou sonores peuvent être associées à des franchissements de seuils par les paramètres déterminés selon l'invention.

De préférence, le module 4 offre à l'utilisateur une interface adaptée qui permet de sélectionner un ou plusieurs paramètres à surveiller, ainsi qu'un de ces niveaux de précision pour chaque paramètre.

Le module 4 peut intégrer ou être relié à une mémoire (non représentée) pour mémoriser les résultats fournis par le module 3.

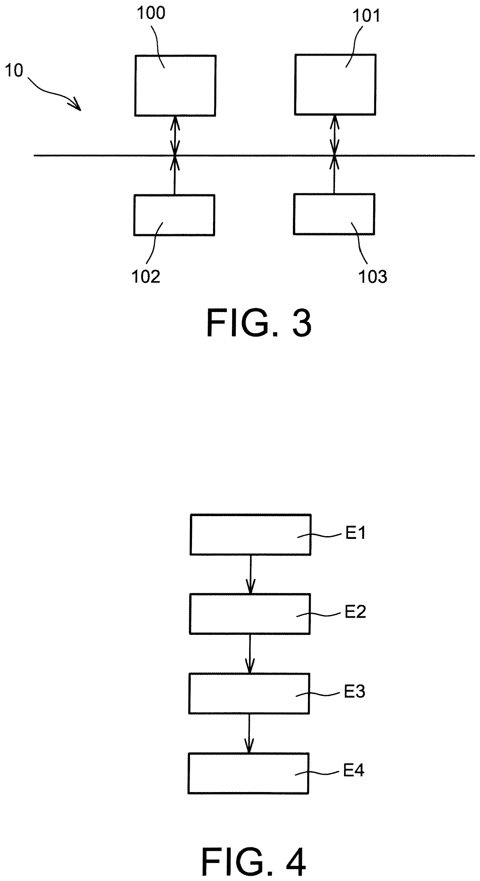

La **figure 3** représente un mode de réalisation particulier du dispositif selon l'invention.

Le dispositif 10 a la structure générale d'un ordinateur. Il comporte notamment un processeur 100 exécutant un programme d'ordinateur mettant en œuvre le procédé selon l'invention, une mémoire 101, une interface d'entrée 102 et une interface de sortie 103 pour afficher les résultats des calculs effectués par le processeur.

Ces différents éléments sont classiquement reliés par un bus.

L'interface d'entrée 102 est destinée à être connectée aux phases du réseau triphasé, de manière à effectuer des mesures de tension et/ou de courant.

Le processeur 100 exécute les traitements précédemment exposés en référence aux figures 1 et 2. Ces traitements sont réalisés sous la forme d'instructions de code du programme d'ordinateur qui sont mémorisées par la mémoire 101 avant d'être exécutées par le processeur 100.

La mémoire 101 peut en outre mémoriser les résultats des traitements effectués.

L'interface de sortie 103 permet l'affichage des résultats ou en variante la connexion à un afficheur.

En référence à la **figure 4,** le procédé d'analyse de la qualité de l'énergie électrique dans un réseau électrique triphasé selon l'invention, mis en œuvre par le dispositif précédemment décrit, comporte les étapes E1 à E4.

L'étape E1 est l'acquisition de données. On suppose que l'interface d'entrée du module 1 a été préalablement connectée à chaque phase du réseau électrique triphasé, pour en mesurer des grandeurs électriques instantanées en un point du réseau. Ces grandeurs sont les tensions et/ou les courants des phases.

L'étape E1 est suivie de l'étape E2 qui est la transformation tridimensionnelle instantanée des grandeurs précédemment mesurées. Le résultat est le vecteur d'espace et la composante homopolaire.

L'étape suivante E3 comporte la détermination d'au moins un paramètre représentatif de la qualité de l'énergie électrique dans le réseau électrique triphasé, en fonction du vecteur d'espace.

Si nécessaire, cette détermination est en outre effectuée en fonction de la composante homopolaire.

Les paramètres qui peuvent être déterminés sont choisis parmi :

- Un taux $k_H$ de distorsion harmonique triphasé, qui représente la pollution harmonique de tension ou de courant,
- Un taux $k_D$ de déséquilibre triphasé, qui représente les déséquilibres de tension ou de courant,
- Un indicateur $k_C$ de creux de tension ou de courant triphasé, qui représente les creux de tension ou de courant,
- Un indicateur $k_S$ de surtension ou de surintensité triphasée, qui représente les surtensions ou surintensités,
- Un taux $k_F$ de papillotement de tension, ou « flicker », qui représente les papillotements de tension.

Les calculs pour déterminer ces paramètres sont ceux précédemment exposés.

L'étape E3 peut en outre comporter la détermination d'au moins un paramètre énergétique du réseau électrique triphasé en fonction du vecteur d'espace et de la composante homopolaire.

Les paramètres énergétiques qui peuvent être déterminés sont choisis parmi :

- les valeurs efficaces totales, dites valeurs RMS (de l'anglais Root Mean Square) de la tension et/ou du courant,
- différentes puissances totales, telles que puissances totales active, réactive et apparente. Ces puissances servent de base au calcul de la consommation énergétique du système triphasé.

Les calculs pour déterminer ces paramètres sont ceux précédemment exposés.

De préférence, l'étape E3 comporte une configuration préalable dans laquelle l'utilisateur sélectionne le ou les paramètres qu'il souhaite déterminer à l'aide d'une interface utilisateur adaptée.

L'étape E3 est suivie de l'étape E4 qui est l'affichage des résultats de l'étape E3. Comme précédemment exposé, l'affichage peut être fait selon plusieurs niveaux de détail. En outre, il peut comporter des alarmes en cas de détection de perturbations.

L'invention s'applique à la détection rapide et précise des différentes perturbations dans les réseaux électriques triphasés.

Elle permet également de détecter la présence de sources polluantes et la direction de propagation des perturbations qu'elles engendrent, particulièrement dans un réseau de grande taille.

L'invention permet par exemple de surveiller les perturbations provoquées par des générateurs éoliens introduits dans un réseau. Un générateur éolien provoque typiquement une pollution harmonique et des papillotements de tension de type « flicker ».

Les inventeurs ont montré expérimentalement que l'invention permet de détecter ces perturbations.

**Revendications**

1. Procédé d'analyse de la qualité de l'énergie électrique dans un réseau électrique triphasé, le procédé comportant les étapes de :

   - Mesure (E1) d'un ensemble de grandeurs électriques, l'ensemble comportant une grandeur électrique par phase,
   - Formation (E2) d'un vecteur d'espace à partir d'une transformation tridimensionnelle instantanée de l'ensemble des grandeurs électriques mesurées,
   - Détermination (E3) d'un ensemble comportant au moins un paramètre représentatif de la qualité de l'énergie électrique dans le réseau électrique triphasé, en fonction du vecteur d'espace,ledit ensemble comportant au moins un paramètre représentatif de la qualité de l'énergie électrique dans le réseau électrique triphasé comportant au moins un paramètre choisi parmi :

      - un paramètre ($k_D$) représentatif d'un déséquilibre de tension ou de courant dans le réseau triphasé,
      - un paramètre ($k_C$) représentatif d'un creux de tension ou de courant,
      - un paramètre ($k_S$) représentatif d'une surtension ou d'une surintensité,
      - un paramètre ($k_F$) représentatif d'un papillotement de tension,

      - la formation d'une composante homopolaire à partir de la transformation tridimensionnelle instantanée de l'ensemble des grandeurs électriques mesurées,

   ladite détermination de l'ensemble comportant au moins un paramètre représentatif de la qualité de l'énergie électrique dans le réseau électrique triphasé est en outre effectuée en fonction de la composante homopolaire et en ce que ledit au moins un paramètre ($k_H$) représente une pollution harmonique de tension ou de courant.

2. Procédé d'analyse selon la revendication 1, comportant en outre la détermination d'au moins un paramètre énergétique du réseau électrique triphasé en fonction du vecteur d'espace et de la composante homopolaire.

3. Procédé d'analyse selon la revendication 2, dans lequel l'au moins un paramètre énergétique est choisi parmi :

- Une valeur efficace totale ($X_{RMS}$) de courant ou de tension,
- Une puissance active totale triphasée (P),
- Une puissance apparente totale triphasée (S),
- Une puissance réactive totale triphasée (Q).

4. Procédé d'analyse selon l'une quelconque des revendications 1 à 3, comportant en outre une étape (E4) d'affichage d'une forme parcourue par le vecteur d'espace dans le plan complexe.

5. Dispositif d'analyse de la qualité de l'énergie électrique dans un réseau électrique triphasé, le dispositif comportant :

- Des moyens (1) de mesure d'un ensemble de grandeurs électriques, l'ensemble comportant une grandeur électrique par phase,
- Des moyens (2) de formation d'un vecteur d'espace à partir d'une transformation tridimensionnelle instantanée de l'ensemble des grandeurs électriques mesurées,
- des moyens (3) de détermination d'un ensemble comportant au moins un paramètre représentatif de la qualité de l'énergie électrique dans le réseau électrique triphasé, en fonction du vecteur d'espace, lesdits moyens de détermination étant adaptés pour déterminer un ensemble comportant au moins un paramètre représentatif de la qualité de l'énergie électrique dans le réseau électrique triphasé choisi parmi :

  - un paramètre ($k_D$) représentatif d'un déséquilibre de tension ou de courant dans le réseau triphasé
  - un paramètre ($k_C$) représentatif d'un creux de tension ou de courant,
  - un paramètre ($k_S$) représentatif d'une surtension ou d'une surintensité,
  - un paramètre ($k_F$) représentatif d'un papillotement de tension,

- des moyens (2) de formation d'une composante homopolaire à partir de la transformation tridimensionnelle instantanée de l'ensemble des grandeurs électriques mesurées,

lesdits moyens de détermination de l'ensemble comportant au moins un paramètre représentatif de la qualité de l'énergie électrique dans le réseau électrique triphasé sont adaptés pour effectuer en outre la détermination en fonction de la composante homopolaire et en ce qu'ils sont adaptés pour déterminer un paramètre ($k_H$) représentatif d'une pollution harmonique de tension ou de courant.

6. Dispositif d'analyse selon la revendication 5, comportant en outre des moyens (3) de détermination d'au moins un paramètre énergétique du réseau électrique triphasé en fonction du vecteur d'espace et de la composante homopolaire.

7. Dispositif d'analyse selon la revendication 6, dans lequel l'au moins un paramètre énergétique est choisi parmi :

- Une valeur efficace totale de courant ou de tension ($X_{RMS}$),
- Une puissance active totale triphasée (P),
- Une puissance apparente totale triphasée (S),
- Une puissance réactive totale triphasée (Q).

8. Dispositif d'analyse selon l'une quelconque des revendications 5 à 7, comportant en outre des moyens (4) d'affichage d'une forme parcourue par le vecteur d'espace dans le plan complexe.

9. Programme d'ordinateur comportant des instructions pour l'exécution des étapes du procédé selon l'une quelconque des revendications 1 à 4 lorsque ledit programme est exécuté par un ordinateur.

10. Support d'enregistrement lisible par un ordinateur sur lequel est enregistré un programme d'ordinateur comprenant des instructions pour l'exécution des étapes du procédé selon l'une quelconque des revendications 1 à 4.

**Patentansprüche**

1. Verfahren zur Qualitätsanalyse elektrischer Energie in einem Drehstromnetzwerk, wobei das Verfahren die folgenden Schritte umfasst:

   - Messung (E1) einer Gesamtheit von elektrischen Größen, wobei die Gesamtheit eine elektrische Größe pro Phase umfasst,
   - Bildung (E2) eines Raumvektors aus einer sofortigen dreidimensionalen Umwandlung der Gesamtheit der gemessenen elektrischen Größen,
   - Bestimmung (E3) einer Gesamtheit, die mindestens einen Parameter umfasst, der für die Qualität der elektrischen Energie im Drehstromnetzwerk repräsentativ ist, in Abhängigkeit vom Raumvektor, wobei die Gesamtheit mindestens einen Parameter umfasst, der für die Qualität der elektrischen Energie im Drehstromnetzwerk repräsentativ ist und mindestens einen Parameter umfasst, der ausgewählt ist aus:

     - einem Parameter ($k_D$), der für ein Spannungs- oder Stromungleichgewicht im Drehstromnetzwerk repräsentativ ist,
     - einem Parameter ($k_c$), der für einen Spannungs- oder Stromabfall repräsentativ ist,
     - einem Parameter ($k_s$), der für eine Überspannung oder einen Überstrom repräsentativ ist,
     - einem Parameter ($k_F$), der für ein Spannungsflickern repräsentativ ist,
     - die Bildung einer Nullstromkomponente aus der sofortigen dreidimensionalen Umwandlung der Gesamtheit der gemessenen elektrischen Größen,

   die Bestimmung der Gesamtheit, die mindestens einen Parameter umfasst, der für die Qualität der elektrischen Energie im Drehstromnetzwerk repräsentativ ist, ferner in Abhängigkeit von der Nullstromkomponente durchgeführt wird, und dass der mindestens eine Parameter ($k_H$) für eine Spannungs- oder Stromoberschwingung repräsentativ ist.

2. Analyseverfahren nach Anspruch 1, ferner umfassend die Bestimmung mindestens eines Energieparameters des Drehstromnetzwerks in Abhängigkeit von dem Raumvektor und der Nullstromkomponente.

3. Analyseverfahren nach Anspruch 2, wobei der mindestens eine Energieparameter ausgewählt ist aus:

   - einem Gesamteffektivwert ($X_{RMS}$) des Stroms oder der Spannung,
   - einer Dreiphasen-Gesamtwirkleistung (P),
   - einer Dreiphasen-Gesamtscheinleistung (S),
   - einer Dreiphasen-Gesamtblindleistung (Q).

4. Analyseverfahren nach einem der Ansprüche 1 bis 3, ferner umfassend einen Schritt (E4) der Anzeige einer vom Raumvektor durchquerten Form in der komplexen Ebene.

5. Gerät zur Qualitätsanalyse elektrischer Energie in einem Drehstromnetzwerk, wobei das Gerät umfasst:

   - Mittel (1) zur Messung einer Gesamtheit von elektrischen Größen, wobei die Gesamtheit eine elektrische Größe pro Phase umfasst,
   - Mittel (2) zur Bildung eines Raumvektors aus einer sofortigen dreidimensionalen Umwandlung der Gesamtheit der gemessenen elektrischen Größen,
   - Mittel (3) zur Bestimmung einer Gesamtheit, die mindestens einen Parameter umfasst, der für die Qualität der elektrischen Energie im Drehstromnetzwerk repräsentativ ist, in Abhängigkeit vom Raumvektor, wobei die Mittel zur Bestimmung dazu angepasst sind, eine Gesamtheit zu bestimmen, die mindestens einen Parameter umfasst, der für die Qualität der elektrischen Energie im Drehstromnetzwerk repräsentativ ist und der ausgewählt ist aus:

     - einem Parameter ($k_D$), der für ein Spannungs- oder Stromungleichgewicht im Drehstromnetzwerk repräsentativ ist,
     - einem Parameter ($k_c$), der für einen Spannungs- oder Stromabfall repräsentativ ist,

- einem Parameter ($k_S$), der für eine Überspannung oder einen Überstrom repräsentativ ist,
- einem Parameter ($k_F$), der für ein Spannungsflickern repräsentativ ist,
- Mittel (2) zur Bildung einer Nullstromkomponente aus der sofortigen dreidimensionalen Umwandlung der Gesamtheit der gemessenen elektrischen Größen,

die Mittel zur Bestimmung der Gesamtheit, die mindestens einen Parameter umfassen, der für die Qualität der elektrischen Energie im Drehstromnetzwerk repräsentativ ist, angepasst sind, um ferner die Bestimmung in Abhängigkeit der Nullpunktkomponente durchzuführen und dass sie angepasst sind, um einen Parameter ($k_H$) zu bestimmen, der für eine Spannungs- oder Stromoberschwingung repräsentativ ist.

6. Analysegerät nach Anspruch 5, ferner umfassend Mittel (3) zur Bestimmung mindestens eines Energieparameters des Drehstromnetzwerks in Abhängigkeit von dem Raumvektor und der Nullstromkomponente.

7. Analysegerät nach Anspruch 6, wobei der mindestens eine Energieparameter ausgewählt ist aus:

- einem Gesamteffektivwert ($X_{RMS}$) des Stroms oder der Spannung,
- einer Dreiphasen-Gesamtwirkleistung (P),
- einer Dreiphasen-Gesamtscheinleistung (S),
- einer Dreiphasen-Gesamtblindleistung (Q).

8. Analysegerät nach einem der Ansprüche 5 bis 7, ferner umfassend Mittel (4) zur Anzeige einer vom Raumvektor durchquerten Form in der komplexen Ebene.

9. Computerprogramm, das Anweisungen zur Ausführung der Schritte des Verfahrens nach einem der Ansprüche 1 bis 4 umfasst, wenn das Programm von einem Computer ausgeführt wird.

10. Datenaufzeichnungsmedium, das von einem Rechner lesbar ist, auf dem ein Computerprogramm gespeichert ist, umfassend Anweisungen zur Ausführung der Schritte des Verfahrens nach einem der Ansprüche 1-4.

**Claims**

1. Method for analysing the quality of the electrical energy in a three-phase electrical network, the method comprising the steps of:

- measuring (E1) a set of electrical values, the set containing one electrical value per phase,
- forming (E2) a space vector from an instantaneous three-dimensional transformation of the set of measured electrical values,
- determining (E3) a set containing at least one parameter representative of the quality of the electrical energy in the three-phase electrical network, on the basis of the space vector, said set containing at least one parameter representative of the quality of the electrical energy in the three-phase electrical network containing at least one parameter chosen from among:

- a parameter ($k_D$) representative of a voltage or current imbalance in the three-phase network,
- a parameter (kc) representative of a voltage or current sag,
- a parameter (ks) representative of an overvoltage or of an overcurrent,
- a parameter ($k_F$) representative of a voltage flicker,

- forming a zero-sequence component from the instantaneous three-dimensional transformation of the set of measured electrical values,

said determination of the set containing at least one parameter representative of the quality of the electrical energy in the three-phase electrical network is furthermore performed depending on the zero-sequence component, and in that said at least one parameter ($k_H$) represents a voltage or current harmonic pollution.

2. Analysis method according to Claim 1, furthermore comprising determining at least one energy parameter of the three-phase electrical network on the basis of the space vector and of the zero-sequence component.

3. Analysis method according to Claim 2, wherein the at least one energy parameter is chosen from among:

   - a total rms current or voltage value (XRMS),
   - a total three-phase active power (P),
   - a total three-phase apparent power (S),
   - a total three-phase reactive power (Q).

4. Analysis method according to any one of Claims 1 to 3, furthermore comprising a step (E4) of displaying a form taken by the space vector in the complex plane.

5. Device for analysing the quality of the electrical energy in a three-phase electrical network, the device comprising:

   - means (1) for measuring a set of electrical values, the set containing one electrical value per phase,
   - means (2) for forming a space vector from an instantaneous three-dimensional transformation of the set of measured electrical values,
   - means (3) for determining a set containing at least one parameter representative of the quality of the electrical energy in the three-phase electrical network, on the basis of the space vector, said determination means being designed to determine a set containing at least one parameter representative of the quality of the electrical energy in the three-phase electrical network chosen from among:

     - a parameter ($k_D$) representative of a voltage or current imbalance in the three-phase network,
     - a parameter ($k_C$) representative of a voltage or current sag,
     - a parameter (ks) representative of an overvoltage or of an overcurrent,
     - a parameter ($k_F$) representative of a voltage flicker,

   - means (2) for forming a zero-sequence component from the instantaneous three-dimensional transformation of the set of measured electrical values,

   said means for determining the set containing at least one parameter representative of the quality of the electrical energy in the three-phase electrical network are furthermore designed to perform the determination depending on the zero-sequence component, and in that they are designed to determine a parameter ($k_H$) representative of a voltage or current harmonic pollution.

6. Analysis device according to Claim 5, furthermore comprising means (3) for determining at least one energy parameter of the three-phase electrical network on the basis of the space vector and of the zero-sequence component.

7. Analysis device according to Claim 6, wherein the at least one energy parameter is chosen from among:

   - a total rms current or voltage value (XRMS),
   - a total three-phase active power (P),
   - a total three-phase apparent power (S),
   - a total three-phase reactive power (Q).

8. Analysis device according to any one of Claims 5 to 7, furthermore comprising means (4) for displaying a form taken by the space vector in the complex plane.

9. Computer program containing instructions for executing the steps of the method according to any one of Claims 1 to 4 when said program is executed by a computer.

10. Computer-readable recording medium on which there is recorded a computer program comprising instructions for executing the steps of the method according to any one of Claims 1 to 4.

FIG. 1

FIG. 2

100

101

10

102

103

# FIG. 3

E1

E2

E3

E4

# FIG. 4

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 0599648 A

**Littérature non-brevet citée dans la description**

- A park-vector approach to displacement and distortion in three-phase systems: the role of the power factor and the imaginary power. **FERRERO A et al.** HARMONICS AND QUALITY OF POWER, 2004. 11TH INTERNATIONAL CONFERENCE ON LAKE PLACID, NY, USA 12-15 SEPT. 2004. IEEE, 12 Septembre 2004, 745-752

- Power quality assessment in V-V, Clarke and Park domain. **CHATTOPADHYAY S et al.** UNIVERSITIES POWER ENGINEERING CONFERENCE, 2007. UPEC 2007. 42ND INTERNATIONAL. IEEE, 04 Septembre 2007, 669-676